(19) Europäisches Patentamt
European Patent Office
Office européen des brevets

(11) **EP 3 025 403 B1**

(12) **EUROPÄISCHE PATENTSCHRIFT**

(45) Veröffentlichungstag und Bekanntmachung des Hinweises auf die Patenterteilung:
**15.04.2020 Patentblatt 2020/16**

(21) Anmeldenummer: **14739805.1**

(22) Anmeldetag: **15.07.2014**

(51) Int Cl.:
*H02J 3/36* (2006.01)   *H02M 1/32* (2007.01)
*H02M 7/483* (2007.01)

(86) Internationale Anmeldenummer:
**PCT/EP2014/065069**

(87) Internationale Veröffentlichungsnummer:
**WO 2015/036149 (19.03.2015 Gazette 2015/11)**

(54) **MODULARER MEHRPUNKTSTROMRICHTER FÜR HOHE SPANNUNGEN**

MODULAR MULTIPOINT POWER CONVERTER FOR HIGH VOLTAGES

CONVERTISSEUR MULTIPOINTS MODULAIRE POUR TENSIONS ÉLEVÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.09.2013 DE 102013218207**

(43) Veröffentlichungstag der Anmeldung:
**01.06.2016 Patentblatt 2016/22**

(73) Patentinhaber: **Siemens Aktiengesellschaft 80333 München (DE)**

(72) Erfinder: **MARQUARDT, Rainer 85521 Ottobrunn/Riemerling (DE)**

(56) Entgegenhaltungen:
**DE-A1-102009 057 288**

- **WANG YEQI ET AL: "Future HVDC-grids employing modular multilevel converters and hybrid DC-breakers", 2013 15TH EUROPEAN CONFERENCE ON POWER ELECTRONICS AND APPLICATIONS (EPE), IEEE, 2. September 2013 (2013-09-02), Seiten 1-8, XP032505277, DOI: 10.1109/EPE.2013.6631861 [gefunden am 2013-10-14]**
- **MARQUARDT R: "Modular Multilevel Converter: An universal concept for HVDC-Networks and extended DC-Bus-applications", 2010 INTERNATIONAL POWER ELECTRONICS CONFERENCE : IPEC-SAPPORO 2010 - [ECCE ASIA] ; SAPPORO, JAPAN, IEEE, PISCATAWAY, NJ, USA, 21. Juni 2010 (2010-06-21), Seiten 502-507, XP031729731, ISBN: 978-1-4244-5394-8**

**Beschreibung**

Die Erfindung betrifft ein zweipoliges Submodul zum Ausbilden eines Umrichters. Das besagte Submodul umfasst dabei eine erste Untereinheit, die einen ersten Energiespeicher, eine dem ersten Energiespeicher parallel geschaltete erste Reihenschaltung zweier Leistungshalbleiterschalteinheiten, die jeweils einen an und abschaltbaren Leistungshalbleiter mit gleicher Durchlassrichtung aufweisen und jeweils entgegen der besagten Durchlassrichtung leitfähig sind, und eine erste Anschlussklemme aufweist, die mit dem Potenzialpunkt zwischen den Leistungshalbleiterschalteinheiten der ersten Reihenschaltung verbunden ist. Ferner umfasst das Submodul eine zweite Untereinheit, die einen zweiten Energiespeicher, eine dem zweiten Energiespeicher parallel geschaltete zweite Reihenschaltung zweier Leistungshalbleiterschalteinheiten, die jeweils einen an und abschaltbaren Leistungshalbleiter mit gleicher Durchlassrichtung aufweisen und jeweils entgegen der besagten Durchlassrichtung leitfähig sind, und eine zweite Anschlussklemme aufweist, die mit dem Potenzialpunkt zwischen den Leistungshalbleiterschalteinheiten der zweiten Reihenschaltung verbunden ist. Die erste Untereinheit und die zweite Untereinheit sind ferner über Verbindungsmittel miteinander verbunden. Die besagten Verbindungsmittel weisen einen Emitterverbindungszweig, der einen Emitter einer ersten Leistungshalbleiterschalteinheit der ersten Reihenschaltung mit einem Emitter einer ersten Leistungshalbleiterschalteinheit der zweiten Reihenschaltung verbindet, einen Kollektorverbindungszweig, der einen Kollektor der zweiten Leistungshalbleiterschalteinheit der ersten Reihenschaltung mit einem Kollektor der zweiten Leistungshalbleiterschalteinheit der zweiten Reihenschaltung verbindet, und einen Schaltzweig auf, in dem eine Schalteinheit angeordnet ist und der den Emitterverbindungszweig mit dem Kollektorverbindungszweig verbindet.

Ferner betrifft die Erfindung einen Umrichter mit einer Reihenschaltung solcher zweipoliger Submodule, wobei die Reihenschaltung der Submodule zwischen einem Wechselspannungsanschluss und einem Gleichspannungsanschluss des Umrichters angeordnet ist.

Der Einsatz leistungselektronischer Systeme im Bereich sehr hoher Spannungen und Leistungen hat zunehmend an Bedeutung gewonnen. Vorwiegend werden die leistungselektronischen Systeme zur Steuerung des Energieflusses zwischen verschiedenen Energieversorgungsnetzen (Netzkupplungen, Hochspannungsgleichstromübertragung (HGÜ)) eingesetzt. Insbesondere für räumlich ausgedehnte, verzweigte Hochspannungsgleichstrom-Netze mit mehreren angeschlossenen Umrichtern ("Multi-Terminal") kann die sichere und schnelle Beherrschung möglicher Störungsfälle von entscheidender Bedeutung sein.

Für die erforderlichen, sehr hohen Leistungen wurden bisher vorwiegend Stromrichter mit Thyristoren und eingeprägtem Gleichstrom eingesetzt. Diese erfüllen jedoch nicht die künftig steigenden Anforderungen bezüglich hochdynamischer Blindleistungskompensation, Netzspannungsstabilisierung, günstiger Einsetzbarkeit von Gleichspannungskabeln und der Realisierbarkeit von verzweigten HGÜ-Netzen. Als bevorzugte Schaltungsart werden deshalb vorwiegend Stromrichter mit eingeprägter Gleichspannung entwickelt. Dieser Stromrichtertyp wird auch als U-Umrichter (Voltage Source Converter, VSC) bezeichnet. Nachteilig bei einigen der üblichen U-Umrichter ist insbesondere, dass bei Kurzschluss der Gleichspannungsseite des Umrichters extrem hohe Entladungsströme aus der gleichspannungsseitigen Kondensatorbatterie fließen, die Zerstörungen in Folge extrem hoher mechanischer Krafteinwirkungen und/oder Lichtbögenwirkungen verursachen können.

Dieser Nachteil bekannter U-Umrichter ist in der Druckschrift DE 10 103 031 A1 thematisiert. Der dort beschriebene Umrichter weist Leistungshalbleiterventile auf, die in einer Brückenschaltung miteinander verbunden sind. Jedes dieser Leistungshalbleiterventile hat einen Wechselspannungsanschluss und einen Gleichspannungsanschluss und besteht aus einer Reihenschaltung zweipoliger Submodule, die jeweils einen unipolaren Speicherkondensator sowie eine Leistungshalbleiterschaltung in Parallelschaltung zum Speicherkondensator aufweisen. Die Leistungshalbleiterschaltung besteht aus einer Reihenschaltung gleichsinnig orientierter Leistungshalbleiterschalter, wie IGBTs oder GTOs, denen jeweils eine Freilaufdiode gegensinnig parallel geschaltet ist. Eine von zwei Anschlussklemmen eines jeden Submoduls ist mit dem Speicherkondensator und die andere Anschlussklemme mit dem Potenzialpunkt zwischen den beiden an- und abschaltbaren Leistungshalbleiterschaltern verbunden. Je nach Schaltzustand der beiden ansteuerbaren Leistungshalbleiter kann entweder die an dem Speicherkondensator anliegende Kondensatorspannung oder aber eine Nullspannung an den beiden Ausgangsklemmen des Submoduls erzeugt werden. Aufgrund der Reihenschaltung der Submodule innerhalb des Leistungshalbleiterventils ist ein sogenannter Gleichspannung einprägender Mehrstufenumrichter bereitgestellt, wobei die Höhe der Spannungsstufen durch die Höhe der jeweiligen Kondensatorspannung festgelegt ist. Derartige Mehrstufen- oder Mehrpunktrichter weisen gegenüber den zwei- oder dreistufigen Umrichtern mit zentralen Kondensatorbatterien den Vorteil auf, dass hohe Entladungsströme bei einem Kurzschluss auf Gleichspannungsseite des Umrichters vermieden sind. Darüber hinaus ist bei mehrstufigen Umrichtern der Aufwand bei der Filterung von Oberschwingungen gegenüber Zwei- oder Dreipunktumrichtern verringert. Entsprechende Topologien werden inzwischen industriell für HGÜ eingesetzt. Einer der Vorteile dieser Topologie - welche aus o. a. Schrift bekannt ist - liegt in ihrer streng modularen Ausgestaltung.

Insbesondere zum Aufbau räumlich ausgedehnter, verzweigter HGÜ-Netze ist jedoch die sichere und schnelle Beherrschung möglicher Störungsfälle im HGÜ-Netz nicht befriedigend gelöst. Entsprechende, räumlich ausgedehnte, verzweigte HGÜ-Netze werden u. a. für große Off-Shore-Windparks und die Nutzung großer Solarkraftwerke in fernen Wüstengebieten zukünftig benötigt. Insbesondere müssen Kurzschlüsse im HGÜ-Netz beherrscht werden können.

Günstige mechanische Schalter für die extrem hohen Gleichspannungen (DC-Spannungen), welche hohe Fehlerströme unter Last schalten können, stehen wegen grundlegender physikalischer Probleme nicht zur Verfügung. Auch die technisch erreichbaren Abschaltzeiten und die Schaltüberspannungen mechanischer Schalter sind störend. Entsprechend dem Stand der Technik sind deshalb mechanische Schalter für diese Anwendungen nur als lastlos (stromlos) schaltende Trenner günstig realisierbar.

Ein direkter Einsatz mechanischer Leistungsschalter durch elektronische DC-Leistungsschalter ist im Hochspannungsbereich extrem aufwändig. Auch die zusätzlichen Durchlassverluste der Halbleiter sprechen dagegen. Aus diesem Grunde sind sogenannte, hybride HGÜ-Schalter entwickelt und publiziert worden, welche zusätzliche mechanische Schalter zwecks Vermeidung und/oder Verringerung der Durchlassverluste enthalten. Durch diese Maßnahme werden jedoch die erreichbaren Abschaltzeiten wieder durch die mechanischen Schalter beeinträchtigt.

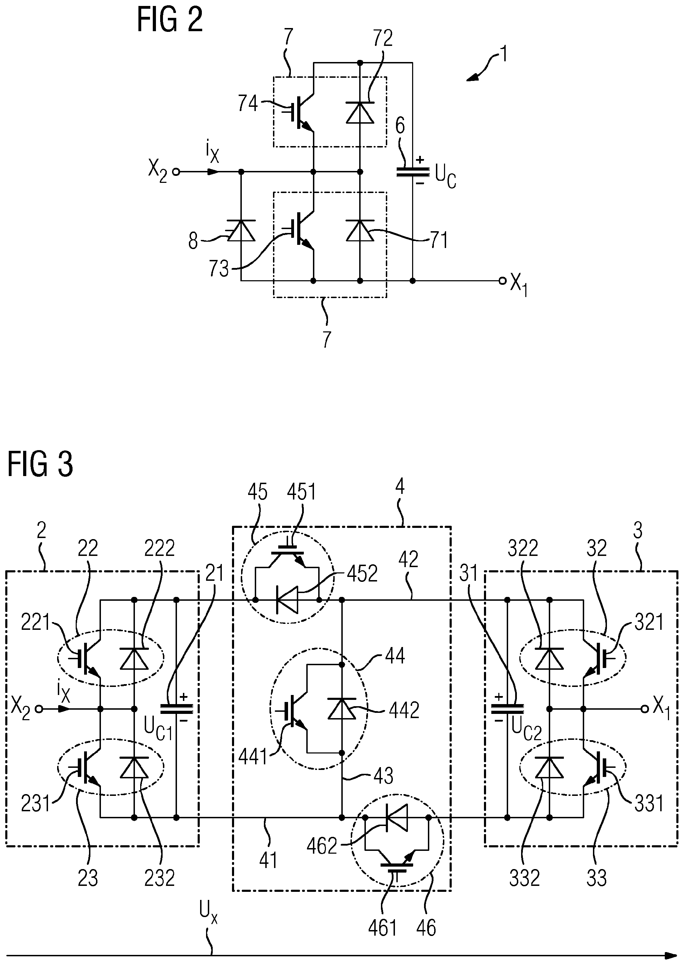

Figur 2 zeigt in schematischer Darstellung ein Beispiel einer Innenschaltung eines Submoduls, wie sie aus dem Stand der Technik bekannt ist. Das in Figur 2 dargestellte Submodul 1 unterscheidet sich von der aus DE 10 103 031 A1 bekannten Ausführung durch einen zusätzlichen Thyristor 8. Dieser dient in Störungsfällen dem Zweck, die parallele Freilaufdiode 71 von unverträglich hohen Stoßströmen zu entlasten. Der Thyristor 8 muss zu diesem Zweck in Störungsfällen gezündet werden. Als weitere Bauelemente enthält das Submodul 1 der Figur 2 in bekannter Anordnung zwei steuerbare, elektronische Schalter 73, 74, i.a.: IGBTs hoher Sperrspannung, zugehörige, antiparallele Freilaufdioden 71, 72 sowie einen Energiespeicher 6, der als unipolarer Speicherkondensator ausgeführt ist.

Bei einer Polarität des Klemmenstromes ix entgegen der in Figur 2 eingezeichneten, technischen Stromrichtung kann das Submodul 1 der Figur 2 unabhängig vom angesteuerten Schaltzustand keine Energie aufnehmen. Diese Tatsache ist in Störungsfällen sehr nachteilig. Sie gilt generell für die Bestückung mit Submodulen, die nur eine Polarität der Klemmenspannung Ux erzeugen können.

Es ist für den Fachmann naheliegend - und aus verschiedenen Veröffentlichungen bekannt - als Submodule sogenannte Vierquadrantsteller (Vollbrücken) einzusetzen (siehe z.B. die Druckschrift DE 102 17 889 A1). Diese können bei jeder Polarität des Klemmenstromes eine entsprechende Gegenspannung erzeugen, d. h.: Energie aufnehmen. Dadurch werden folgende Vorteile ermöglicht:

- Die DC-seitigen und die drehstromseitigen Ströme können bei Netzfehlern - insbesondere bei Kurzschlüssen im DC-Netz - durch die Umrichter selbst elektronisch abgeschaltet und/oder begrenzt werden.

- Die erreichbaren Abschaltzeiten sind kurz gegen die Abschaltzeiten mechanischer Schalter oder hybrider HGÜ-Schalter

- Im Normalbetrieb ist eine höhere AC-Spannung erreichbar, so dass eine Auslegung mit etwas höherer Sekundärspannung des Netztransformators (und resultierend kleinerem AC-Strom) ermöglicht wird. Dies ist ein wertvoller Freiheitsgrad der Dimensionierung.

Äußerst nachteilig ist jedoch die Tatsache, dass sich die Durchlassverlustleistung der Submodule bei gleichem Strom verdoppelt. Insbesondere in der Energieversorgung ist dies aufgrund des Dauerbetriebes bei hohen Leistungen von erheblicher kommerzieller Bedeutung. Bezüglich der Funktionalität im Normalbetrieb ist jedoch der neue Freiheitsgrad einer Dimensionierung auf kleinere AC-Ströme wertvoll.

Ein Umrichter mit dem gattungsgemäßen Submodul ist aus der Druckschrift DE 10 2009 057 288 A1 bekannt. Dort sind im Emitterverbindungszweig und im Kollektorverbindungszweig der Verbindungsmittel jeweils eine Potenzialtrennungsdiode sowie optional ein Dämpfungswiderstand angeordnet. Die Potenzialtrennungsdioden sind derart angeordnet, dass der Schaltzweig der Verbindungsmittel eine Kathode der Potenzialtrennungsdiode des Emitterverbindungszweiges mit einer Anode der Potenzialtrennungsdiode des Kollektorverbindungszweiges verbindet. Durch die Ausbildung der Verbindungsmittel kann bei geeigneter Ansteuerung der Leistungshalbleiterschalteinheiten erreicht werden, dass ein Stromfluss zwischen den beiden Anschlussklemmen des Submoduls immer über wenigstens einen Energiespeicher erfolgen muss. Der jeweils betroffene Energiespeicher baut unabhängig von der Polarisierung des Klemmstromes immer eine Gegenspannung auf, die den Stromfluss schneller abklingen lässt. Nachteilig erweist sich bei dieser Lösung, dass negative Klemmenspannungen nicht für beide Polaritäten des Klemmenstromes ix erzeugt werden können. Dadurch ist der zusätzliche Freiheitsgrad einer Dimensionierung auf kleinere AC-Ströme nicht realisierbar. Diesen Nachteil weist auch die bekannte Anordnung eines Umrichters mit einem an der DC-Seite des Umrichters direkt nachgeschalteten HGÜ-Schalter auf.

Es besteht daher weiterhin hoher Bedarf ein einer technisch günstigeren Realisierung der Submodule als dies mit kaskadierten Vollbrücken möglich ist. Die Aufgabe der vorliegenden Erfindung besteht darin, ein Submodul und einen Umrichter der eingangs genannten Art vorzuschlagen, bei der die Halbleiterverlustleistung der Submodule im Normalbetrieb verringert, die Anzahl der steuerbaren Halbleiterschalter begrenzt und eine einheitliche Bestückung der Submodule mit Halbleitern ermöglicht ist.

Ausgehend vom eingangs genannten Submodul löst die Erfindung die Aufgabe dadurch, dass in dem Emitterverbindungszweig oder dem Kollektorverbindungszweig der Verbindungsmittel des erfindungsgemäßen Submoduls wenigstens eine Leistungshalbleiterschalteinheit angeordnet ist.

Ausgehend vom eingangs genannten Umrichter löst die Erfindung die Aufgabe dadurch, dass jedes Submodul des erfindungsgemäßen Umrichters ein Submodul gemäß der vorliegenden Erfindung ist.

Vorteilhaft ermöglicht das erfindungsgemäße Submodul die angestrebte Beherrschung der Fehlerfälle und ersetzt im Normalbetrieb durch die Möglichkeit der Erzeugung negativer Klemmenspannungen des Submoduls eine Reihenschaltung von zwei Vollbrücken.

Die relevanten Verbesserungen sind je nach Ausgestaltung der Erfindung die Folgenden:

- Eine Verringerung der gesamten Halbleiterverlustleistung der Submodule im Normalbetrieb.

- Eine Begrenzung der Anzahl der steuerbaren Halbleiterschalter (i.a. IGBT) und der gesamten Halbleiterfläche.

- Beibehaltung der Möglichkeit zur Bestückung des Submoduls mit Halbleitern von einheitlicher Sperrspannung und Struktur.

Die beiden erstgenannten Punkte stellen einen wesentlichen Fortschritt gegenüber dem bekannten Einsatz von kaskadierten Vollbrücken dar. Der letztgenannte Punkt ist äquivalent zum Einsatz von Vollbrücken. Seine Bedeutung ist dadurch gegeben, dass für die extrem hohen Spannungen und Leistungen nur wenige Halbleiterschalter geeignet sind. Dies sind gegenwärtig IGBT-Transistoren hoher Sperrspannung oder IGCT - in Zukunft auch SiC-Halbleiter. Eine einheitliche Bestückung ermöglicht es, nur die jeweils bestgeeigneten und leistungsfähigsten Halbleiter einzusetzen.

Die Leistungshalbleiterschalteinheiten können als Halbleiterschalter mit jeweils zugehörigen antiparallelen Dioden oder auch als rückwärtsleitende Halbleiterschalter realisiert sein. Die erforderliche Sperrspannung aller Leistungshalbleiterschalteinheiten orientiert sich an der maximalen Spannung der Energiespeicher, die beispielsweise als unipolare Speicherkondensatoren ausgebildet sind. Vorzugsweise ist die Sperrspannung für alle Leistungshalbleiterschalteinheiten gleich.

Die Erfindung schließt insbesondere eine Ausgestaltung des Submoduls ein, bei der im Emitterverbindungszweig wenigstens eine Leistungshalbleiterschalteinheit und im Kollektorverbindungszweig wenigstens eine Potenzialtrennungsdiode angeordnet ist.

Entsprechend ist auch eine Ausführungsform möglich, bei der die wenigstens eine Potenzialtrennungsdiode im Emitterverbindungszweig und der wenigstens eine Leistungshalbleiterschalter im Kollektorverbindungszweig angeordnet ist.

Die wenigstens eine Potenzialtrennungsdiode dient dabei zum Aufrechterhalten einer Spannungsdifferenz zwischen der ersten und der zweiten Untereinheit des Submoduls.

Gemäß einer bevorzugten Ausführungsform der Erfindung ist sowohl in dem Emitterverbindungszweig wie auch in dem Kollektorverbindungszweig der Verbindungsmittel jeweils wenigstens eine Leistungshalbleiterschalteinheit vorgesehen. Diese Ausführungsform weist den Vorteil auf, dass negative Spannungen an den Anschlussklemmen des Submoduls erzeugt werden können, die den Spannungen der Energiespeicher der Untereinheiten entsprechen.

Der Schaltzweig kann beispielsweise einen Emitter der im Kollektorverbindungszweig angeordneten Leistungshalbleiterschalteinheit der Verbindungsmittel mit einem Kollektor der im Emitterverbindungszweig angeordneten Leistungshalbleiterschalteinheit der Verbindungsmittel verbinden.

Die Schalteinheit des Schaltzweigs kann als eine mechanische Schalteinheit, ein Halbleiterschalter oder eine Leistungshalbleiterschalteinheit realisiert sein.

Gemäß eines Ausführungsbeispiels der Erfindung ist die Schalteinheit im Schaltzweig der Verbindungsmittel eine Leistungshalbleiterschalteinheit. Der Emitter der im Kollektorverbindungszweig angeordneten Leistungshalbleiterschalteinheit ist mit dem Kollektor der Leistungshalbleiterschalteinheit des Schaltzweigs verbunden und der Emitter der Leistungshalbleiterschalteinheit des Schaltzweigs des Schaltzweigs ist mit dem Kollektor der im Emitterverbindungszweig angeordneten Leistungshalbleiterschalteinheit verbunden.

In jedem Fall ist es von Vorteil, wenn die Schalteinheit derart gewählt ist, dass die an ihr bei Normalbetrieb des Submoduls entstehende Verlustleistung möglichst gering ist.

Abhängig von der Topologie des Submoduls kann ein Schaltzustand der Leistungshalbleiterschalteinheiten des Submoduls definiert werden, in dem das Submodul unabhängig von der Stromrichtung Energie aufnimmt. Vorzugsweise nimmt das Submodul in einem Schaltzustand, in dem alle Leistungshalbleiterschalteinheiten in ihrer Unterbrecherstellung sind, unabhängig von der Stromrichtung Energie auf. Werden demnach alle Leistungshalbleiterschalteinheiten in ihre Unterbrecherstellung gebracht, so kann das Submodul vorteilhaft unabhängig von der Stromrichtung eine Gegenspannung zum Abbau des Stromes im Fehlerfall aufbauen. Erfindungsgemäß kann somit ein hoher Kurzschlussstrom ohne externe zusätzliche Schalter beherrscht werden. Im Rahmen der Erfindung ist sichergestellt, dass hohe Kurzschlussströme durch den Umrichter selbst in beiden Richtungen schnell, zuverlässig und wirksam vermieden werden können. Zusätzliche Schalter, beispielsweise im Gleichspannungskreis, der mit dem Umrichter verbunden ist, oder aber parallel zu einem Leistungshalbleiter des Submoduls geschaltete Halbleiterschalter, sind im Rahmen der Erfindung überflüssig. Im Fehlerfall nehmen nahezu ausschließlich die Submodule die frei gewordene Energie auf, so dass diese vollständig absorbiert wird. Die Energieaufnahme hat eine Gegenspannung im Gefolge und kann in definierter Weise durch die Dimensionierung der Kondensatoren bemessen werden. Dadurch können ungünstig hohe Spannungen vermieden werden. Ferner müssen zum Wiederanfahren des Umrichters keine Energiespeicher kontrolliert aufgeladen werden. Vielmehr kann der erfindungsgemäße Umrichter seinen Normalbetrieb nach einer elektronischen Abschaltung jederzeit wieder aufnehmen.

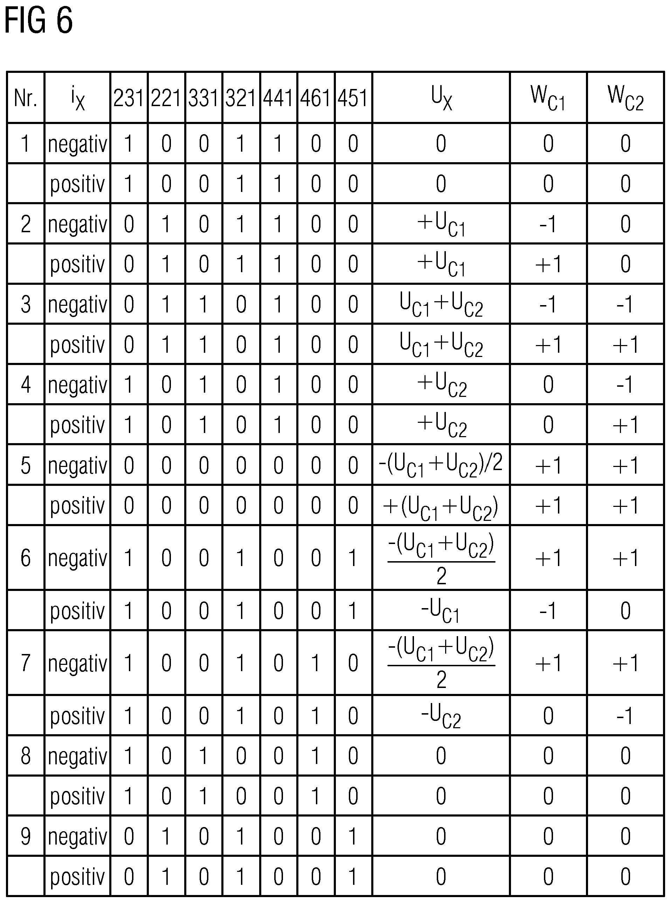

Weitere nutzbare Schaltzustände, die Gegenspannung generieren, sind im Zusammenhang mit dem in Figur 6 dargestellten Ausführungsbeispiel angegeben. Diese sind jeweils dadurch hervorgehoben, dass eines oder beide Vorzeichen (vgl. Wc1, Wc2 in Figur 6) positiv sind, wodurch Energieaufnahme der betreffenden Energiespeicher angedeutet ist.

Vorzugsweise sind die Leistungshalbleiterschalteinheiten rückwärts leitende, an- und abschaltbare Leistungshalbleiterschalter.

Die Leistungshalbleiterschalteinheiten können jeweils auch einen an- und abschaltbaren Leistungshalbleiter umfassen, dem eine Freilaufdiode gegensinnig parallel geschaltet ist.

Gemäß eines Ausführungsbeispiels der Erfindung ist jeder Energiespeicher des Submoduls ein unipolarer Speicherkondensator.

Gemäß einer weiteren Ausführungsform der Erfindung weisen die Verbindungsmittel einen zweiten Schaltzweig auf, der den Emitterschaltzweig mit dem Kollektorschaltzweig verbindet, und in dem eine Leistungshalbleiterschalteinheit angeordnet ist. Die im ersten Schaltzweig angeordnete Leistungshalbleiterschalteinheit ist hierbei in Parallelschaltung zu der im zweiten Schaltzweig angeordneten Leistungshalbleiterschalteinheit geschaltet. Aus dieser Ausführungsform resultiert der Vorteil einer reduzierten Durchlassverlustleistung. Darüber hinaus sind zwischen den Untereinheiten angeordnete Verbindungsleitungen unkritisch bezüglich ihrer Länge und Streuinduktivität. Dies ermöglicht eine konstruktiv und räumlich getrennte Bauweise beider durch die Verbindungsleitungen miteinander verbundenen Teileinheiten des Submoduls, so dass erhebliche Vorteile für die industrielle Serienproduktion und den Service entstehen.

Grundsätzlich sind auch erfindungsgemäße Ausführungen der Submodule realisierbar, die drei oder mehr kaskadierte Vollbrücken ersetzen. Dazu können die Verbindungsmittel mit drei oder mehr Schaltzweigen ausgestattet sein, in denen weitere Leistungshalbleiterschalteinheiten, Energiespeicher oder andere Bauteile angeordnet sein können. Die relativen Vorteile solcher Ausführungsformen können jedoch gegenüber den oben beschriebenen Ausführungsformen unter Umständen abnehmen.

Es lässt sich feststellen, dass die Durchlassverlustleistung je nach Ausführung des Submoduls und je nach Halbleiterdurchlasskennlinie gegenüber kaskadierten Vollbrücken im Allgemeinen um einen Faktor von 0,5 bis 0,8 reduziert werden kann.

An folgenden, beispielhaften Durchlasskennlinien sei dies erläutert. Weisen alle Leistungshalbleiter eine rein ohmsche Durchlasskennlinie in beiden Stromrichtungen auf - wie dies mit entsprechend angesteuerten Feldeffekt-Transistoren der Fall wäre - so gilt für zwei konventionelle, kaskadierte Vollbrücken die Durchlassverlustleistung:

$$P_F = (I_{XRMS})^2 \cdot 4 \cdot R_0$$

wobei $I_{XRMS}$ den Effektivwert des Zweigstromes und $R_0$ den Durchlasswiderstand pro Leistungshalbleiter bezeichnen. Für das Ausführungsbeispiel nach Figur 3 gilt:

$$P_F{}' = (I_{XRMS})^2 \cdot 3 \; R_0$$

wobei die benötigte Halbleiterfläche zusätzlich auf 7/8 reduziert ist. Bei gleicher, gesamter Halbleiterfläche kann der Durchlasswiderstand pro Leistungshalbleiter auf $R_0{}' = 7/8 \cdot R_0$ reduziert werden, so dass die Verlustleistung noch geringer wird.

Die Erfindung wird im Folgenden anhand der Figuren 1 bis 6 näher erläutert.

Figur 1 zeigt ein Ausführungsbeispiel eines Mehrstufenumrichters in einer schematischen Darstellung;

Figur 2 zeigt ein Submodul aus dem Stand der Technik;

Figur 3 zeigt ein erstes Ausführungsbeispiel eines erfindungsgemäßen Submoduls in einer schematischen Darstellung;

Figur 4 zeigt ein zweites Ausführungsbeispiel des erfindungsgemäßen Submoduls in einer schematischen Darstellung;

Figur 5 zeigt ein drittes Ausführungsbeispiel des erfindungsgemäßen Submoduls in einer schematischen Darstellung;

Figur 6 zeigt eine tabellarische Übersicht von Schaltzuständen des erfindungsgemäßen Submoduls.

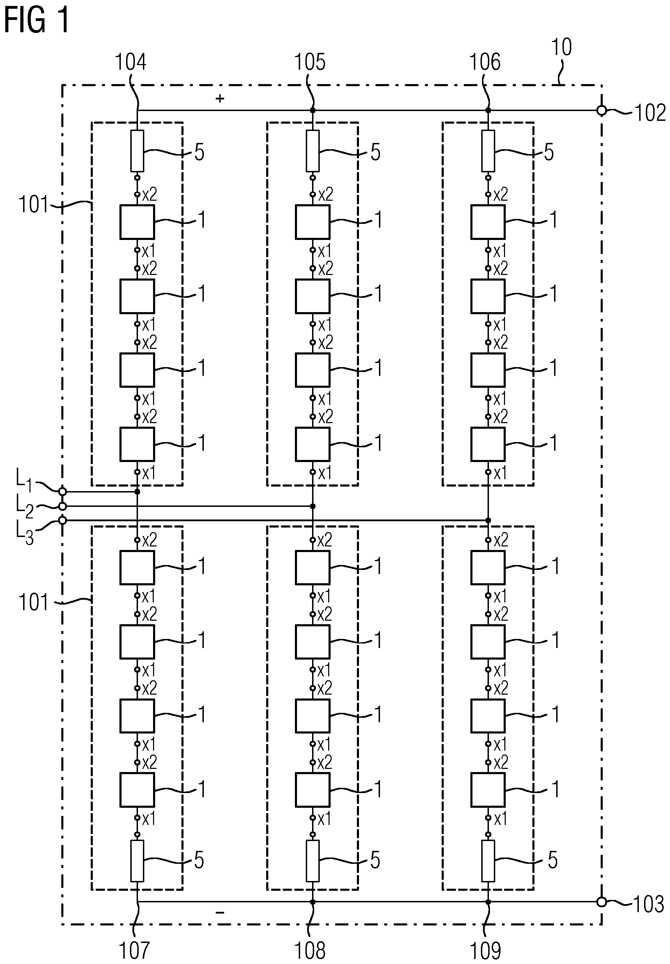

Im Einzelnen ist in Figur 1 ein Umrichter 10 dargestellt, wobei der Umrichter 10 als Mehrstufenumrichter ausgebildet ist. Der Umrichter 10 weist drei Wechselspannungsanschlüsse L1, L2, L3 zum Anschluss an ein dreiphasiges Wechselspannungsnetz auf. Ferner umfasst der Umrichter 10 Gleichspannungsanschlüsse 104, 105, 106, 107, 108 und 109 zum Anschluss an einen positiven Polanschluss 102 und einen negativen Polanschluss 103.

Der positive Polanschluss 102 und der negative Polanschluss 103 sind mit einem positiven bzw. einem negativen Pol eines in Figur 1 nicht dargestellten Gleichspannungsnetzes verbindbar.

Die Wechselspannungsanschlüsse L1, L2, L3 sind jeweils mit einer Sekundärwicklung eines Transformators verbindbar. Die Primärwicklung des Transformators ist an ein in Figur 1 nicht dargestelltes Wechselspannungsnetz angeschlossen. Auch die direkte galvanische Verbindung mit dem Wechselspannungsnetz beispielsweise unter Zwischenschaltung einer Spule oder Drossel oder eines kapazitiven Bauteils ist im Rahmen der Erfindung möglich.

Zwischen je einem der Gleichspannungsanschlüsse 104, 105, 106, 107, 108, 109 und einem der Wechselspannungsanschlüsse L1, L2, L3 erstrecken sich Leistungshalbleiterventile 101. Jeder der Leistungshalbleiterventile 101 weist eine Reihenschaltung von Submodulen 1 auf.

Des Weiteren verfügt jedes Leistungshalbleiterventil 101 über eine Drossel 5.

Jedes der zweipoligen Submodule 1, die in der in Figur 1 gezeigten Ausführungsform identisch ausgebildet sind, weist zwei stromtragende Anschlüsse X1 und X2 auf.

In dem in Figur 1 gezeigten Ausführungsbeispiel ist der Umrichter 10 Teil einer HGÜ-Anlage und dient zur Verbindung von Wechselspannungsnetzen über ein Hochspannungsgleichstromnetz. Der Umrichter 10 ist dazu eingerichtet, zwischen den Wechselspannungsnetzen hohe elektrische Leistungen zu übertragen. Der Umrichter 10 kann jedoch auch Teil einer Blindleistungskompensations-/Neztstabilisierungsanlage, wie zum Beispiel einer sogenannten FACTS-Anlage, sein. Darüber hinaus sind weitere Anwendungen des Umrichters 10, wie beispielsweise in der Antriebstechnik, denkbar.

Der grundsätzliche Aufbau einer Ausführungsform eines erfindungsgemäßen Submoduls 1 ist in Figur 3 dargestellt.

Das Submodul 1 umfasst eine erste Untereinheit 2 sowie eine zweite Untereinheit 3, die jeweils zur Darstellungszwecken durch eine unterbrochene Linie gekennzeichnet sind. Die erste Untereinheit 2 und die zweite Untereinheit 3 weisen den gleichen Aufbau auf.

Die erste Untereinheit 2 umfasst eine erste Reihenschaltung aus Leistungshalbleiterschalteinheiten 22 und 23, die in der gezeigten Ausführungsvariante jeweils einen IGBT 221 bzw. 231 als an- und abschaltbare Leistungshalbleiter und jeweils eine Freilaufdiode 222 bzw. 232 aufweisen. Die Freilaufdioden 222, 232 sind dem jeweilig zugeordneten IGBT 221, 231 gegensinnig parallel geschaltet. Die beiden IGBTs 221, 231 sind zueinander gleichsinnig orientiert, weisen also gleiche Durchlassrichtung auf. Der Potenzialpunkt zwischen den Leistungshalbleiterschalteinheiten 22, 23 ist mit einer ersten Anschlussklemme X2 verbunden. Die Reihenschaltung der beiden Leistungshalbleiterschalteinheiten 22 und 23 ist parallel zu einem ersten Energiespeicher, der als Kondensator 21 realisiert ist, geschaltet. An dem Kondensator 21 fällt eine Spannung UC1 ab.

Die zweite Untereinheit 3 umfasst eine erste Reihenschaltung aus Leistungshalbleiterschalteinheiten 32 und 33, die jeweils einen IGBT 321 bzw. 331 als anund abschaltbare Leistungshalbleiter und jeweils eine Freilaufdiode 322 bzw. 332 aufweisen. Die Freilaufdioden 322, 332 sind dem jeweilig zugeordneten IGBT 321, 331 gegensinnig parallel geschaltet. Die beiden IGBTs 321, 331 sind zueinander gleichsinnig orientiert, weisen also gleiche Durchlassrichtung auf. Der Potenzialpunkt zwischen den Leistungshalbleiterschalteinheiten 32, 33 ist mit einer zweiten Anschlussklemme X1 verbunden. Die Reihenschaltung der beiden Leistungshalbleiterschalteinheiten 32 und 33 ist parallel zu einem ersten Energiespeicher, der als Kondensator 31 realisiert ist, geschaltet. An dem Kondensator 31 fällt eine Spannung UC2 ab.

Die Untereinheiten 2 und 3 sind über Verbindungsmittel 4 miteinander verknüpft. Die Verbindungsmittel 4 sind zu Darstellungszwecken in Figur 3 mit einer unterbrochenen Linie umrissen. Die Verbindungsmittel 4 umfassen einen Emitterverbindungszweig 41 sowie einen Kollektorverbindungszweig 42.

Der Emitterverbindungszweig 41 verbindet einen Emitter des IGBTs 231 mit einem Emitter des IGBTs 331. In dem Emitterverbindungszweig 41 ist eine Leistungshalbleiterschalteinheit 46 angeordnet. Die Leistungshalbleiterschalteinheit 46 umfasst einen IGBT 461 und eine dazu gegensinnig parallel geschaltete Diode 462.

Der Kollektorverbindungszweig 42 verbindet einen Kollektor des IGBTs 221 mit dem Kollektor des IGBTs 321. In dem Kollektorverbindungszweig 42 ist eine Leistungshalbleiterschalteinheit 45 angeordnet. Die Leistungshalbleiterschalteinheit 45 umfasst einen IGBT 451 und eine dazu gegensinnig parallel geschaltete Diode 452.

Der Emitterverbindungszweig 41 ist mit dem Kollektorverbindungszweig 42 über einen Schaltzweig 43 verbunden. In dem Schaltzweig 43 ist eine Schalteinheit angeordnet, die gemäß dem in Figur 3 dargestellten Ausführungsbeispiel als Leistungshalbleiterschalteinheit 44 ausgebildet ist. Die Leistungshalbleiterschalteinheit 44 umfasst einen IGBT 441 sowie eine gegensinnig parallel dazu geschaltete Diode 442. Der Schaltzweig 43 verbindet den Emitter des IGBTs 451 mit dem Kollektor des IGBTs 461.

Die Wirkungsweise der Schaltung des erfindungsgemäßen Submoduls 1 soll im Folgenden anhand der in Figur 6 dargestellten Tabelle näher erörtert werden, wobei die Tabelle der Figur 6 die bevorzugt genutzten Schaltzustände des Submoduls 1 zusammenfasst.

In der ersten Spalte der Tabelle in Figur 6 findet sich die einem Schaltzustand zugeordnete fortlaufende Nummer; in der zweiten Spalte findet sich die Information über die Stromrichtung/-polarität des Klemmstromes ix; in der dritten bis neunten Spalte ist jeweils ein Zustand der einzelnen IGBTs mit der Ziffer 1 für "eingeschaltet" und 0 für „unterbrechend" ausgewiesen, wobei jeder IGBT anhand der zugehörigen Zahlenkennzeichnung aus Figur 3 identifizierbar ist; in der zehnten Spalte findet sich die dem jeweiligen Schaltzustand zugehörige Klemmenspannung UX; die Spalten WC1 und WC2 sollen verdeutlichen, ob die Speicherkondensatoren 21 und 31 Energie auf- oder abgeben, wobei +1 für die Aufnahme und -1 für die Abgabe von Energie steht.

Der Tabelle der Figur 6 ist entnehmbar, dass in den Schaltzuständen 2, 3 und 4 an den Anschlussklemmen X1 und X2 immer eine positive Spannung UX erzeugt ist. Dies gilt unabhängig von der Richtung des Klemmstromes. So kann beispielsweise die Kondensatorspannung UC1 oder die Kondensatorspannung UC2 oder aber die die Summe der beiden Kondensatorspannungen UC1+UC2 an den Anschlussklemmen erzeugt werden.

Im Schaltzustand 5 sind alle IGBTs 231, 221, 331, 321, 441, 451, 461 in ihrer Unterbrecherstellung, so dass der Stromfluss über die IGBTs 231, 221, 331, 321, 441, 451, 461 unterbrochen ist. In diesem Schaltzustand bildet die Klemmenspannung UX unabhängig von der Polarität des Klemmstromes ix eine Gegenspannung aus, so dass das Submodul 1 Energie aufnimmt.

Bei negativer Stromrichtung (Stromrichtung entgegen der Richtung des mit ix gekennzeichneten Pfeils) gilt näherungsweise durch eine eigenständige Symmetrierung der Kondensatorspannungen UC1 und UC2, dass UX=-(UC1+UC2)/2. Bei positiver Stromrichtung (Stromrichtung in Richtung des mit ix gekennzeichneten Pfeils) wird eine positive Gegenspannung UX=UC1+UC2 aufgebaut. Dabei ist es vorteilhaft, dass der auftretende Strom in diesem Schaltzustand über beide Kondensatoren geführt wird, da an diesen dann eine geringere Überspannung auftritt, als wenn nur ein Kondensator die Energie aufnehmen müsste.

Der Schaltzustand 5 ist im Fehlerfall zum vollständigen Stromabbau einsetzbar. Werden alle Submodule 1 in diesen Schaltzustand überführt, werden die Zweigströme des Umrichters 10 und resultierend auch die wechselspannungs- und gleichspannungsseitigen Ströme in Folge der Summe der Gegenspannungen aller reihengeschalteter Submodule 1 sehr schnell auf den Wert Null abgebaut. Die Geschwindigkeit dieses Stromabbaus ergibt sich aus der oben genannten Gegenspannung und den in den Stromkreisen summarisch vorhandenen Induktivitäten. Sie kann bei dem gezeigten Ausführungsbeispiel typischerweise in der Größenordnung weniger Millisekunden liegen. Die Totzeit bis zum Beginn des Stromabbaus ist im Wesentlichen von der Ansprechzeit der Schalteinheit 44 abhängig. Wird für die Schalteinheit 44 eine Leistungshalbleiterschalteinheit eingesetzt, ist diese Totzeit vernachlässigbar. Die Totzeit ist dann im Wesentlichen der Trägheit der verschiedenen Messsensoren und Stromwandler geschuldet, mit deren Hilfe ein Störfall erkannt wird. Diese Trägheit dieser Messwerteerfassung liegt derzeit typischerweise im Bereich einiger 10 Mikrosekunden.

Es ist anzumerken, dass die ersten vier Schaltzustände auch mit zwei kaskadierten Submodulen aus dem Stand der Technik gemäß der Figur 2 realisierbar sind. Mit dem gemäß der Druckschrift DE 10 2009 057 288 A1 ausgebildeten Submodul lassen sich die ersten fünf der Schaltzustände realisieren.

Im Schaltzustand 6 wird eine negative Klemmenspannung UX des Submoduls 1 bei beliebiger Stromrichtung generiert.

Im Schaltzustand 7 wird ebenfalls eine negative Klemmenspannung UX des Submoduls 1 bei beliebiger Stromrichtung generiert.

Des Weiteren sind zusätzliche (redundante) Schaltzustände 8 und 9 möglich, welche zur glichmäßigeren Verteilung der Durchlassverluste bei UX=0 genutzt werden können.

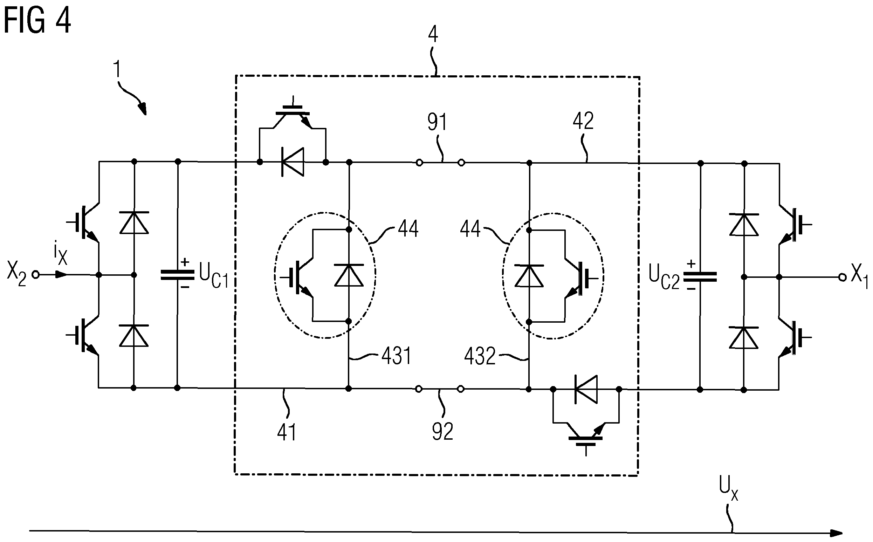

In Figur 4 ist ein zweites Ausführungsbeispiel des Submoduls 1 gemäß der Erfindung dargestellt. Dabei sind gleiche und gleichartige Teile in den Figuren 3, 4 und 5 jeweils mit gleichen Bezugszeichen versehen. Zur Vermeidung von Wiederholungen wird daher im Folgenden nur auf die Unterschiede in den einzelnen Ausführungsformen näher eingegangen.

Das Submodul 1 gemäß der Figur 4 unterscheidet sich von der Ausführungsform der Figur 3 dadurch, dass die Verbindungsmittel 4 in Figur 4 zwei Schaltzweige 431 und 432 umfassen. Jeder der Schaltzweige umfasst eine Leistungshalbleiterschalteinheit 44.

Zwischen den Schaltzweigen 431 und 432 sind als Teile des Emitter- bzw. Kollektorverbindungszweiges 41, 42 Verbindungsleitungen 91 und 92 angeordnet. Der besondere Vorteil der Ausführungsform der Figur 4 ist, dass die Verbindungsleitungen 91, 92 bezüglich ihrer Länge und Streuinduktivität unkritisch für die Gesamtperformance des Submoduls 1 sind. Die Verbindungsleitungen können somit eine Länge aufweisen, die an die jeweilige Anwendung angepasst ist. Eine konstruktiv und räumlich getrennte bzw. angepasste Bauweise des Submoduls 1 kann für die Produktion und den Service von großem Vorteil sein.

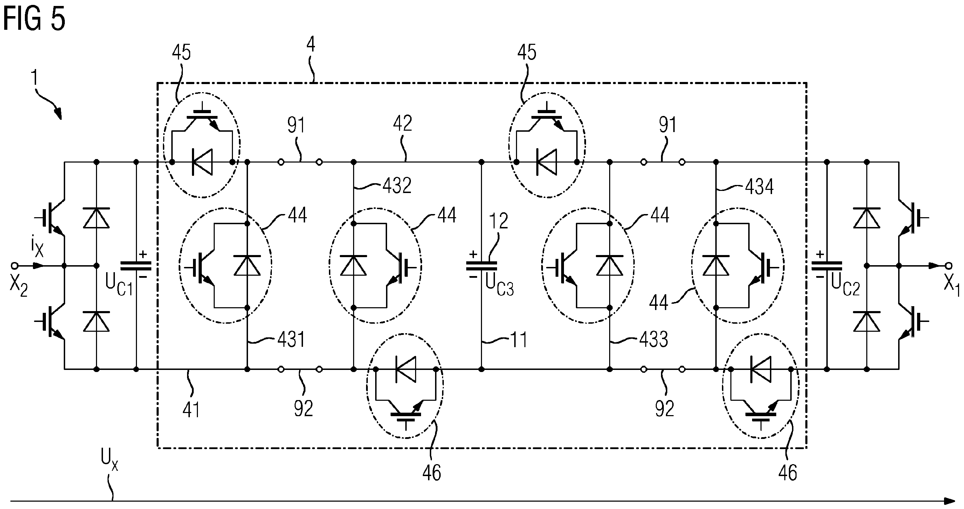

In Figur 5 ist eine dritte Ausführungsform des erfindungsgemäßen Submoduls 1 schematisch dargestellt. Hierbei weist der Emitterverbindungszweig der Verbindungsmittel 4 zwei Verbindungsleitungen 92 sowie zwei Leistungshalbleiterschalteinheiten 45 auf. Der Kollektorverbindungszweig 42 der Verbindungsmittel 4 weist ebenfalls zwei Verbindungsleitungen 91 sowie zwei Leistungshalbleiterschalteinheiten 46 auf.

Ferner umfassen die Verbindungsmittel 4 vier Schaltzweige 431, 432, 433 und 434, wobei in jedem Schaltzweig eine Leistungshalbleiterschalteinheit 44 angeordnet ist. Zudem umfassen die Verbindungsmittel 4 einen Energiespeicherzweig 11, in dem ein dritter Energiespeicher 12 angeordnet ist, der im vorliegenden Beispiel als unipolarer Speicherkondensator ausgebildet ist, an dem die Spannung UC3 abfällt.

Bezugszeichentabelle

| | |
|---|---|
| 1 | Submodul |
| 2 | erste Untereinheit |
| 21 | erster Energiespeicher |
| 22, 23 | Leistungshalbleiterschalteinheit |
| 221, 231 | Leistungshalbleiter |
| 222, 232 | Freilaufdiode |
| 3 | zweite Untereinheit |
| 31 | zweiter Energiespeicher |
| 32, 33 | Leistungshalbleiterschalteinheit |
| 321, 331 | Leistungshalbleiter |
| 322, 332 | Freilaufdiode |
| 4 | Verbindungsmittel |
| 41 | Emitterverbindungszweig |
| 42 | Kollektorverbindungszweig |
| 43, 431, 432 | Schaltzweig |
| 433, 434 | Schaltzweig |
| 44 | Schalteinheit |
| 45, 46 | Leistungshalbleiterschalteinheit |
| 441, 451, 461 | Leistungshalbleiter |
| 442, 452, 462 | Freilaufdiode |
| 5 | Drossel |
| 6 | Energiespeicher |
| 7 | Leistungshalbleiterschalteinheit |
| 71, 72 | Freilaufdiode |
| 73, 74 | elektronischer Schalter |
| 8 | Thyristor |
| 91, 92 | Verbindungsleitung |
| 10 | Umrichter |
| 101 | Leistungshalbleiterventil |
| 102 | positiver Polanschluss |
| 103 | negativer Polanschluss |
| 104, 105, 106 | Gleichspannungsanschluss |
| 107, 108, 109 | Gleichspannungsanschluss |
| 11 | Energiespeicherzweig |
| 12 | dritter Energiespeicher |
| L1, L2, L3 | Wechselspannungsanschluss |
| X1 | zweite Anschlussklemme |
| X2 | erste Anschlussklemme |

**Patentansprüche**

1.  Submodul (1) zum Ausbilden eines Umrichters (10) mit einer ersten Untereinheit (2), die

- einen ersten Energiespeicher (21),
- eine dem ersten Energiespeicher (21) parallel geschaltete erste Reihenschaltung zweier Leistungshalbleiterschalteinheiten (22,23), die jeweils einen an und abschaltbaren Leistungshalbleiter (221,231) mit gleicher Durchlassrichtung aufweisen und jeweils entgegen der besagten Durchlassrichtung leitfähig sind, und
- eine erste Anschlussklemme (X2) aufweist, die mit dem Potenzialpunkt zwischen den Leistungshalbleiterschalteinheiten (22,23) der ersten Reihenschaltung verbunden ist, und

einer zweiten Untereinheit (3), die

- einen zweiten Energiespeicher (31),
- eine dem zweiten Energiespeicher (31) parallel geschaltete zweite Reihenschaltung zweier Leistungshalbleiterschalteinheiten (32,33), die jeweils einen an und abschaltbaren Leistungshalbleiter (321,331) mit gleicher Durchlassrichtung aufweisen und jeweils entgegen der besagten Durchlassrichtung leitfähig sind, und
- eine zweite Anschlussklemme (X1) aufweist, die mit dem Potenzialpunkt zwischen den Leistungshalbleiterschalteinheiten (32,33) der zweiten Reihenschaltung verbunden ist, wobei

die erste Untereinheit (2) und die zweite Untereinheit (3) über Verbindungsmittel (4) miteinander verbunden sind, wobei die Verbindungsmittel (4) einen Emitterverbindungszweig (41), der einen Emitter einer ersten Leistungshalbleiterschalteinheit (23) der ersten Reihenschaltung mit einem Emitter einer ersten Leistungshalbleiterschalteinheit (33) der zweiten Reihenschaltung verbindet, aufweisen, und die Verbindungsmittel (4) einen Kollektorverbindungszweig (42), der einen Kollektor der zweiten Leistungshalbleiterschalteinheit (22) der ersten Reihenschaltung mit einem Kollektor der zweiten Leistungshalbleiterschalteinheit (32) der zweiten Reihenschaltung verbindet, aufweisen, und die Verbindungsmittel (4) einen Schaltzweig (43) aufweisen, in dem eine Schalteinheit (44) angeordnet ist und der den Emitterverbindungszweig (41) mit dem Kollektorverbindungszweig (42) verbindet,
    **dadurch gekennzeichnet, dass**
    in dem Emitterverbindungszweig (41) oder dem Kollektorverbindungszweig (42) wenigstens eine Leistungshalbleiterschalteinheit (45, 46) angeordnet ist, die einen an- und abschaltbaren Leistungshalbleiter aufweist.

2.  Submodul (1) nach Anspruch 1,
    **dadurch gekennzeichnet, dass**
    in dem Emitterverbindungszweig (41) und dem Kollektorverbindungszweig (42) jeweils wenigstens eine Leistungshalbleiterschalteinheit (45, 46) angeordnet ist.

**3.** Submodul (1) nach Anspruch 2,
**dadurch gekennzeichnet, dass**
der Schaltzweig (43) einen Emitter der im Kollektorverbindungszweig (42) angeordneten Leistungshalbleiterschalteinheit (45) mit einem Kollektor der im Emitterverbindungszweig (41) angeordneten Leistungshalbleiterschalteinheit (46) verbindet.

**4.** Submodul (1) nach einem der vorangehenden Ansprüche,
**dadurch gekennzeichnet, dass**
die Schalteinheit (44) eine mechanische Schalteinheit, ein Halbleiterschalter oder eine Leistungshalbleiterschalteinheit ist.

**5.** Submodul (1) nach einem der vorangehenden Ansprüche,
**dadurch gekennzeichnet, dass**
in einem Schaltzustand des Submoduls (1), in dem alle Leistungshalbleiterschalteinheiten (22, 23, 32, 33, 44, 45, 46) in ihrer Unterbrecherstellung sind, das Submodul (1) unabhängig von der Stromrichtung Energie aufnimmt.

**6.** Submodul (1) nach einem der vorangehenden Ansprüche,
**dadurch gekennzeichnet, dass**
die Leistungshalbleiterschalteinheiten (22, 23, 32, 33, 44, 45, 46) rückwärts leitende, an- und abschaltbare Leistungshalbleiterschalter sind.

**7.** Submodul (1) nach einem der Ansprüche 1 bis 5,
**dadurch gekennzeichnet, dass**
jede Leistungshalbleiterschalteinheit (22, 23, 32, 33, 44, 45, 46) jeweils einen an- und abschaltbaren Leistungshalbleiter (221, 231, 321, 331, 441, 451, 461) aufweist, dem eine Freilaufdiode (222, 232, 322, 332, 442, 452, 462) gegensinnig parallel geschaltet ist.

**8.** Submodul (1) nach einem der vorangehenden Ansprüche,
**dadurch gekennzeichnet, dass**
jeder Energiespeicher (21, 31) ein unipolarer Speicherkondensator ist.

**9.** Submodul (1) nach einem der vorangehenden Ansprüche,
**dadurch gekennzeichnet, dass**
die Verbindungsmittel (4) einen zweiten Schaltzweig aufweisen, der den Emitterschaltzweig mit dem Kollektorschaltzweig verbindet, und in dem eine Leistungshalbleiterschalteinheit angeordnet ist.

**10.** Umrichter (10) mit einer Reihenschaltung von zweipoligen Submodulen (1), wobei die Reihenschaltung der Submodule (1) zwischen einem Wechselspannungsanschluss (L1, L2, L3) und einem Gleichspannungsanschluss (102, 103) des Umrichters (10) angeordnet ist,
**dadurch gekennzeichnet, dass**
jedes Submodul (1) ein Submodul (1) gemäß einem der Ansprüche 1 bis 9 ist.

## Claims

**1.** Submodule (1) for constructing a converter (10) with a first subunit (2) that comprises

- a first energy store (21),
- a first series circuit connected in parallel with the first energy store (21), said series circuit having two power semiconductor switching units (22, 23), each of which comprises a power semiconductor (221, 231) that can be switched on and off and has the same forward conduction directions, and each of which is capable of conducting in a direction opposite to said forward conduction direction, and
- a first connecting terminal (X2) which is connected to the potential node between the power semiconductor switching units (22, 23) of the first series circuit, and

a second subunit (3) that comprises

- a second energy store (31),
- a second series circuit connected in parallel with the second energy store (31), said series circuit having two power semiconductor switching units (32, 33), each of which comprises a power semiconductor (321, 331) that can be switched on and off and has the same forward conduction directions, and each of which is capable of conducting in a direction opposite to said forward conduction direction, and
- a second connecting terminal (X1) which is connected to the potential node between the power semiconductor switching units (32, 33) of the second series circuit, wherein the first subunit (2) and the second subunit (3) are connected to one another via connecting means (4), wherein the connecting means (4) comprise an emitter connecting branch (41) that connects an emitter of a first power semiconductor switching unit (23) of the first series circuit to an emitter of a first power semiconductor switching unit (33) of the second series circuit, and the connecting means (4) comprise a collector connecting branch (42) that connects a collector of the second power semiconductor switching unit (22) of the first series circuit to a collector of the second power semiconductor switching unit (32) of the second series circuit, and the connecting means (4) comprise a switching branch (43) in which a switching unit (44) is arranged and which connects the emitter connecting branch (41) to the collector connecting branch (42),

**characterized in that**
at least one power semiconductor switching unit (45, 46) is arranged in the emitter connecting branch (41) or the collector connecting branch (42), which power semiconductor switching unit comprises a power semiconductor that can be switched on and off.

2. Submodule (1) according to Claim 1,
**characterized in that**
at least one power semiconductor switching unit (45, 46) is arranged in the emitter connecting branch (41) and at least one in the collector connecting branch (42).

3. Submodule (1) according to Claim 2,
**characterized in that**
the switching branch (43) connects an emitter of the power semiconductor switching unit (45) arranged in the collector connecting branch (42) to a collector of the power semiconductor switching unit (46) arranged in the emitter connecting branch (41).

4. Submodule (1) according to one of the preceding claims,
**characterized in that**
the switching unit (44) is a mechanical switching unit, a semiconductor switch or a power semiconductor switching unit.

5. Submodule (1) according to one of the preceding claims,
**characterized in that**,
in a switching state of the submodule (1) in which all the power semiconductor switching units (22, 23, 32, 33, 44, 45, 46) are in their interrupting state, the submodule (1) absorbs energy regardless of the current direction.

6. Submodule (1) according to one of the preceding claims,
**characterized in that**
the power semiconductor switching units (22, 23, 32, 33, 44, 45, 46) are reverse-conducting power semiconductor switches that can be switched on and off.

7. Submodule (1) according to one of Claims 1 to 5,
**characterized in that**
each power semiconductor switching unit (22, 23, 32, 33, 44, 45, 46) comprises a power semiconductor (221, 231, 321, 331, 441, 451, 461) that can be switched on and off, with which a freewheeling diode (222, 232, 322, 332, 442, 452, 462) is connected in parallel but with the opposite polarity.

8. Submodule (1) according to one of the preceding claims,
**characterized in that**
each energy store (21, 31) is a unipolar storage capacitor.

9. Submodule (1) according to one of the preceding claims,
**characterized in that**
the connecting means (4) comprise a second switching branch that connects the emitter switching branch to the collector switching branch, and in which a power semiconductor switching unit is arranged.

10. Converter (10) with a series circuit of two-pole submodules (1), wherein the series circuit of the submodules (1) is arranged between an AC voltage terminal (L1, L2, L3) and a DC voltage terminal (102, 103) of the converter (10),
**characterized in that**
each submodule (1) is a submodule (1) according to one of Claims 1 to 9.

**Revendications**

1. Sous-module (1) de constitution d'un onduleur (10) ayant
une première sous-unité (2), qui a

 - un premier accumulateur (21) d'énergie,
 - un premier circuit série, monté en parallèle avec le premier accumulateur (21) d'énergie, de deux unités (22, 23) de coupure à semi-conducteur de puissance, qui ont chacune un semi-conducteur (221, 231) de puissance, pouvant être mis à l'état passant et à l'état bloqué, de même sens passant et qui sont conductrices, respectivement, dans le sens contraire audit sens passant, et
 - une première borne (X2) de connexion, qui est reliée au point de potentiel entre les unités (22, 23) de coupure à semi-conducteur de puissance du premier circuit série, et

une deuxième sous-unité (3), qui a

 - un deuxième accumulateur (31) d'énergie,
 - un deuxième circuit série, monté en parallèle avec le deuxième accumulateur (31) d'énergie, de deux unité (32, 33) de coupure à semi-conducteur de puissance, qui ont chacune un semi-conducteur (321, 331) de puissance, pouvant être mis à l'état passant et à l'état bloqué, de même sens passant et qui sont conductrices, respectivement, dans le sens contraire audit sens passant, et

- une deuxième borne (X1) de connexion, qui est reliée au point de potentiel entre les unités (32, 33) de coupure à semi-conducteur de puissance du deuxième circuit série, dans lequel

la première sous-unité (2) et la deuxième sous-unité (3) sont reliées entre elles par des moyens (4) de liaison, les moyens (4) de liaison ayant une branche (41) de liaison d'émetteur, qui relie un émetteur d'une première unité (23) de coupure à semi-conducteur de puissance du premier circuit série à un émetteur d'une première unité (33) de coupure à semi-conducteur de puissance du deuxième circuit série et les moyens (4) de liaison ont une branche (42) de liaison de collecteur, qui relie un collecteur de la deuxième unité (22) de coupure à semi-conducteur de puissance du premier circuit série à un collecteur de la deuxième unité (32) de coupure à semi-conducteur de puissance du deuxième circuit série et les moyens (4) de liaison ont une branche (43) de coupure, dans laquelle est montée une unité (44) de coupure et qui relie la branche (41) de liaison d'émetteur à la branche (42) de liaison de collecteur, **caractérisé en ce que**, dans la branche (41) de liaison d'émetteur ou dans la branche (42) de liaison de collecteur est montée au moins une unité (45, 46) de coupure à semi-conducteur de puissance, qui a un semi-conducteur de puissance pouvant être mis à l'état passant et à l'état bloqué.

2. Sous-module (1) suivant la revendication 1, **caractérisé en ce que**, dans la branche (41) de liaison d'émetteur et dans la branche (42) de liaison de collecteur est montée, respectivement, au moins une unité (45, 46) de coupure à semi-conducteur de puissance.

3. Sous-module (1) suivant la revendication 2, **caractérisé en ce que** la branche (43) de coupure relie un émetteur de l'unité (45) de coupure à semi-conducteur de puissance, montée dans la branche (42) de liaison de collecteur, à un collecteur de l'unité (46) de coupure à semi-conducteur de puissance, montée dans la branche (41) de liaison d'émetteur.

4. Sous-module (1) suivant l'une des revendications précédentes, **caractérisé en ce que** l'unité (44) de coupure est une unité de coupure mécanique, un semi-conducteur de puissance ou une unité de coupure à semi-conducteur de puissance.

5. Sous-module (1) suivant l'une des revendications précédentes, **caractérisé en ce que**, dans un état de commutation du sous-module (1), dans lequel toutes les unités (22, 23, 32, 33, 44, 45, 46) de coupure à semi-conducteur de puissance sont dans leur position d'interruption, le sous-module (1) absorbe de l'énergie indépendamment du sens du courant.

6. Sous-module (1) suivant l'une des revendications précédentes, **caractérisé en ce que** les unités (22, 23, 32, 33, 44, 45, 46) de coupure à semi-conducteur de puissance sont des interrupteurs à semi-conducteur de puissance, pouvant être mis à l'état passant et à l'état bloqué, conduisant en sens inverse.

7. Sous-module (1) suivant l'une des revendications 1 à 5, **caractérisé en ce que** chaque unité (22, 23, 32, 33, 44, 45, 46) de coupure à semi-conducteur de puissance a, respectivement, un semi-conducteur (221, 231, 321, 331, 441, 451, 461) de puissance pouvant être mis à l'état passant et à l'état bloqué, avec lequel une diode (222, 232, 322, 332, 442, 452, 462) de roue libre est montée tête-bêche.

8. Sous-module (1) suivant l'une des revendications précédentes, **caractérisé en ce que** chaque accumulateur (21, 31) d'énergie est un condensateur d'accumulation unipolaire.

9. Sous-module (1) suivant l'une des revendications précédentes, **caractérisé en ce que** les moyens (4) de liaison ont une deuxième branche de coupure, qui relie la branche de coupure d'émetteur à la branche de coupure de collecteur et dans laquelle est montée une unité de coupure à semi-conducteur de puissance.

10. Onduleur (10) ayant un circuit série de deux sous-modules (1) bipolaires, le circuit série des sous-modules (1) étant monté entre une borne (L1, L2, L3) de tension alternative et une borne (102, 103) de tension continue de l'onduleur (10), **caractérisé en ce que** chaque sous-module (1) est un sous-module (1) suivant l'une des revendications 1 à 9.

FIG 1

# FIG 2

# FIG 3

FIG 4

FIG 5

# FIG 6

| Nr. | $i_X$ | 231 | 221 | 331 | 321 | 441 | 461 | 451 | $U_X$ | $W_{C1}$ | $W_{C2}$ |
|---|---|---|---|---|---|---|---|---|---|---|---|
| 1 | negativ | 1 | 0 | 0 | 1 | 1 | 0 | 0 | 0 | 0 | 0 |
|   | positiv | 1 | 0 | 0 | 1 | 1 | 0 | 0 | 0 | 0 | 0 |
| 2 | negativ | 0 | 1 | 0 | 1 | 1 | 0 | 0 | $+U_{C1}$ | -1 | 0 |
|   | positiv | 0 | 1 | 0 | 1 | 1 | 0 | 0 | $+U_{C1}$ | +1 | 0 |
| 3 | negativ | 0 | 1 | 1 | 0 | 1 | 0 | 0 | $U_{C1}+U_{C2}$ | -1 | -1 |
|   | positiv | 0 | 1 | 1 | 0 | 1 | 0 | 0 | $U_{C1}+U_{C2}$ | +1 | +1 |
| 4 | negativ | 1 | 0 | 1 | 0 | 1 | 0 | 0 | $+U_{C2}$ | 0 | -1 |
|   | positiv | 1 | 0 | 1 | 0 | 1 | 0 | 0 | $+U_{C2}$ | 0 | +1 |
| 5 | negativ | 0 | 0 | 0 | 0 | 0 | 0 | 0 | $-(U_{C1}+U_{C2})/2$ | +1 | +1 |
|   | positiv | 0 | 0 | 0 | 0 | 0 | 0 | 0 | $+(U_{C1}+U_{C2})$ | +1 | +1 |
| 6 | negativ | 1 | 0 | 0 | 1 | 0 | 0 | 1 | $\dfrac{-(U_{C1}+U_{C2})}{2}$ | +1 | +1 |
|   | positiv | 1 | 0 | 0 | 1 | 0 | 0 | 1 | $-U_{C1}$ | -1 | 0 |
| 7 | negativ | 1 | 0 | 0 | 1 | 0 | 1 | 0 | $\dfrac{-(U_{C1}+U_{C2})}{2}$ | +1 | +1 |
|   | positiv | 1 | 0 | 0 | 1 | 0 | 1 | 0 | $-U_{C2}$ | 0 | -1 |
| 8 | negativ | 1 | 0 | 1 | 0 | 0 | 1 | 0 | 0 | 0 | 0 |
|   | positiv | 1 | 0 | 1 | 0 | 0 | 1 | 0 | 0 | 0 | 0 |
| 9 | negativ | 0 | 1 | 0 | 1 | 0 | 0 | 1 | 0 | 0 | 0 |
|   | positiv | 0 | 1 | 0 | 1 | 0 | 0 | 1 | 0 | 0 | 0 |

**IN DER BESCHREIBUNG AUFGEFÜHRTE DOKUMENTE**

**In der Beschreibung aufgeführte Patentdokumente**

- DE 10103031 A1
- DE 10217889 A1
- DE 102009057288 A1